# EUROPEAN PATENT APPLICATION

(11) **EP 1 796 377 A1**
(43) Date of publication of application: **13.06.2007**
(21) Application number: 05785697.3
(22) Date of filing: 20.09.2005
(51) Int. Cl.: H04N 5/335, H01L 27/148

(54) **IMAGE PICKUP ELEMENT AND IMAGE PICKUP DEVICE USING THE SAME**

(30) Priority: 24.09.2004 JP 2004277109
(71) Applicant: SHIMADZU CORPORATION, Kyoto-shi, Kyoto 604-8511 (JP)
(72) Inventor: KONDO, Yasushi, c/o SHIMADZU CORPORATION, Kyoto-shi, Kyoto 6048511 (JP)
(74) Representative: Pohlmann, Eckart
(86) International application number: PCT/JP2005/017280
(87) International publication number: WO 2006/033322

(57) **Abstract**

An image sensor and an image pickup apparatus using the same, of this invention, has switching gates for coupling a plurality of storage/vertical transfer CCD cells together between a plurality of different photodiodes. Between a photodiode engaged in measurement by the photodiode, and a photodiode not engaged in the above measurement, a switching gate among the switching gates couples together the storage/vertical transfer CCD cells corresponding to the respective photodiodes. And signal charges of the photodiode are stored and memorized in the storage CCD cells corresponding thereto, and the storage CCD cells corresponding to the photodiode.

## Description

### [TECHNICAL FIELD]

This invention relates to an image sensor, and an image pickup apparatus using the same, for picking up images by converting incident light into electric charges to generate signal charges corresponding to the intensity of the light.

### [BACKGROUND ART]

As this type of image sensor, there exists a CCD (Charge Coupled Device) type solid-state image sensor, for example. In recent years, in order to enable high-speed imaging, such a CCD type solid-state image sensor (hereinafter abbreviated as "CCD") has, arranged adjacent photoelectric converters (e.g. photodiodes) that convert incident light into electric charges to generates signal charges corresponding to the intensity of the light, a plurality of charge storage units (e.g. storage CCD cells) for storing and memorizing the signal charges generated from the photoelectric conversion devices (see Patent Documents 1-3, for example). These photoelectric converters and charge storage units are arranged on a chip.

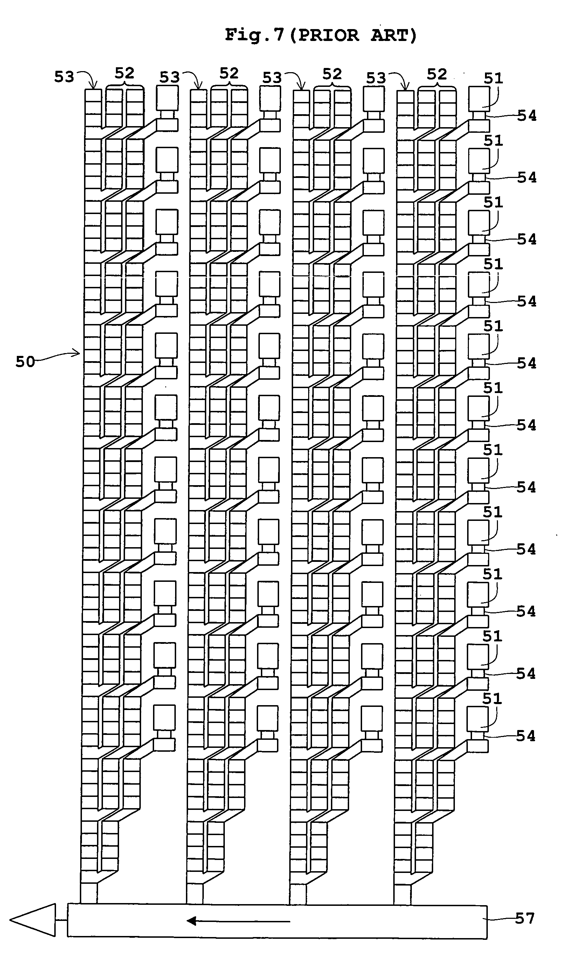

In Patent Documents 1 and 2, a CCD called "slanted CCD type solid-state image sensor" is employed. This slanted CCD type solid-state image sensor will be described with reference to Fig. 7. As shown in Fig. 7, a CCD 50 has a plurality of photodiodes 51 and storage CCD cells 52 as noted above, and has vertical transfer CCD cells 53 for transferring signal charges in these storage CCD cells 52 in a vertical direction shown in Fig. 7.

Each photodiode 51 has a write gate 54 disposed at a side thereof. Each write gate 54 transfers signal charges from this photodiode 51 in a storage CCD cell 52 adjacent thereto.

The storage CCD cells 52 are connected to form lines, respectively, and a plurality of lines of storage CCD cells 52 are arranged. The storage CCD cells 52 in line form are connected at downstream sides to the vertical transfer CCD cells 53. The signal charges generated from the photodiodes 51 are stored in the respective storage CCD cells 52 while transferring them successively to the adjoining storage CCD cells 52. And the signal charges successively transferred from the storage CCD cells 52 are joined to the vertical transfer CCD cells 53. The signal charges transferred from the vertical transfer CCD cells 53 are transferred to horizontal transfer CCD cells 57.

In this "slanted CCD type solid-state image sensor", the storage CCD cells 52 in line form extend in an oblique direction. By using the oblique direction, the photodiodes 51 can be arranged parallel in the horizontal and vertical directions. If the storage CCD cells 52 in line form extended in the vertical direction, the photodiodes would be arranged in the oblique direction. In this "slanted CCD type solid-state image sensor", the photodiodes 51 are not arranged in such a way, but are in a rectangular arrangement.
[Patent Document 1]
   Japanese Unexamined Patent Publication No. 2001-345441 (pages 2 and 5-9, Figs. 2-4, and 10-12)
[Patent Document 2]
   Japanese Unexamined Patent Publication No. 2000-165750 (pages 3 and 6-14, Figs. 1, 4 and 5)
[Patent Document 3]
   Specification of United States Patent No. 5355165

### [DISCLOSURE OF THE INVENTION]

### [PROBLEM TO BE SOLVED BY THE INVENTION]

However, since the photoelectric converters represented by photodiodes and the charge storage units represented by storage CCD cells are arranged on the same chip, there is a problem that an increase in the number of photoelectric converters results in a decrease in the number of charge storage units, and conversely, an increase of the charge storage units results in a decrease of the photoelectric converters. To describe this concretely, when the photoelectric converters are increased in order to enhance resolution, the charge storage units will decrease to reduce each photographing time and the number of photographs. Conversely, when the charge storage units are increased in order to extend photographing time and increase the number of photographs, the photoelectric converters will decrease to lower resolution. Since the arrangement of the photoelectric converters and charge storage units is determined in a design stage, designing with importance placed on either resolution or photographing time and the number of photographs poses a problem that the other will be sacrificed after the designing.

This invention has been made having regard to the state of the art noted above, and its object is to provide an image sensor and an image pickup apparatus using the same, which are highly versatile even for different photographic methods.

### [MEANS FOR SOLVING THE PROBLEM]

To fulfill the above object, this invention provides the following construction.

An image sensor of this invention is an image sensor for picking up images, characterized by comprising (1) a plurality of photoelectric conversion devices for converting incident light into electric charges to generate signal charges corresponding to intensity of the light; (2) a plurality of charge storage devices for storing and memorizing the signal charges generated from the photoelectric conversion devices; and (3) a coupling device for coupling a plurality of charge storage devices together between a plurality of different photoelectric conversion devices, wherein, through the coupling, the charge storage devices corresponding to the respective photoelectric conversion devices are coupled together between a photoelectric conversion device engaged in measurement by said photoelectric conversion, and a photoelectric conversion device not engaged in said measurement, and signal charges of the photoelectric conversion device engaged in said measurement are stored and memorized in the charge storage devices corresponding to the photoelectric conversion device, and the charge storage devices corresponding to the photoelectric conversion device not engaged in said measurement.

According to the image sensor of this invention, a coupling device is provided for coupling a plurality of charge storage devices together between a plurality of different photoelectric conversion devices. Between a photoelectric conversion device engaged in measurement by the photoelectric conversion and a photoelectric conversion device not engaged in the above measurement, the coupling device couples together the charge storage devices corresponding to the respective photoelectric conversion devices. Further, the signal charges of the photoelectric conversion device engaged in the measurement are stored and memorized in the charge storage devices corresponding to the photoelectric conversion device, and the charge storage devices corresponding to the photoelectric conversion device not engaged in the measurement. Therefore, when carrying out photography with importance attached to the number of charge storage devices, the signal charges of the photoelectric conversion device engaged in the measurement are stored and memorized in the charge storage devices corresponding to the photoelectric conversion device, and the charge storage devices corresponding to the photoelectric conversion device not engaged in the measurement, thereby increasing the number of charge storage devices. Thus, the image sensor can be realized as having high versatility even for different photographic methods.

An image pickup apparatus of this invention is an image pickup apparatus using an image sensor, characterized in that the image sensor comprises (1) a plurality of photoelectric conversion devices for converting incident light into electric charges to generate signal charges corresponding to intensity of the light; (2) a plurality of charge storage devices for storing and memorizing the signal charges generated from the photoelectric conversion devices; and (3) a coupling device for coupling a plurality of charge storage devices together between a plurality of different photoelectric conversion devices, wherein, through the coupling, the charge storage devices corresponding to the respective photoelectric conversion devices are coupled together between a photoelectric conversion device engaged in measurement by said photoelectric conversion, and a photoelectric conversion device not engaged in said measurement, and signal charges of the photoelectric conversion device engaged in said measurement are stored and memorized in the charge storage devices corresponding to the photoelectric conversion device, and the charge storage devices corresponding to the photoelectric conversion device not engaged in said measurement.

According to the image pickup apparatus of this invention, a coupling device is provided for coupling a plurality of charge storage devices together between a plurality of different photoelectric conversion devices. Between a photoelectric conversion device engaged in measurement by the photoelectric conversion and a photoelectric conversion device not engaged in the above measurement, the coupling device couples together the charge storage devices corresponding to the respective photoelectric conversion devices. The signal charges of the photoelectric conversion device engaged in the measurement are stored and memorized in the charge storage devices corresponding to the photoelectric conversion device, and the charge storage devices corresponding to the photoelectric conversion device not engaged in the measurement. Thus, the image pickup apparatus can be realized as having high versatility even for different photographic methods.

In these inventions described above, preferably, the measurement is carried out by switching between (a) a state in which the above coupling device couples together the charge storage devices corresponding to the respective photoelectric conversion devices, between the photoelectric conversion device engaged in the above measurement and the photoelectric conversion device not engaged in the measurement, and the measurement is carried out while storing and memorizing the signal charges of the photoelectric conversion device engaged in the measurement in both the charge storage devices, and (b) a state in which both the charge storage devices are uncoupled, and the measurement is carried out while storing and memorizing the signal charges of the individual photoelectric conversion devices in the charge storage devices corresponding to each.

When carrying out photography with importance attached to the number of charge storage devices, measurement is carried out after switching to the state (a) above. That is, the signal charges of the photoelectric conversion device engaged in the measurement are stored and memorized in the charge storage devices corresponding to the photoelectric conversion device, and the charge storage devices corresponding to the photoelectric conversion device not engaged in the measurement, thereby increasing the number of charge storage devices. Conversely, when carrying out photography with importance attached to the number of photoelectric conversion devices, like usual photography, measurement is carried out after switching to the state (b) above. That is, the respective photoelectric conversion devices are not coupled, and measurement is carried out while storing and memorizing the signal charges of the individual photoelectric conversion devices in the charge storage devices corresponding to the respective photoelectric conversion devices, thereby increasing the number of photoelectric conversion devices. Thus, by carrying out measurement after the switching as noted above, the image sensor and image pickup apparatus can be realized as having high versatility, taking into account the usual photographic method according to the state (b).

One example of these inventions noted above comprises (4) a charge transfer control device for controlling charge transfer such that the signal charges of the photoelectric conversion device engaged in the measurement are stored and memorized in the charge storage devices corresponding to the photoelectric conversion device, and the charge storage devices corresponding to the photoelectric conversion device not engaged in the measurement, the coupling device being operable under the control. Thus, the charge transfer control device may be provided for the image sensor, or may be provided for the image pickup apparatus. Where the charge transfer control device is provided for the image pickup apparatus, it may be disposed in the image sensor, or otherwise outside the image sensor.

In these inventions noted above, the photoelectric conversion devices are photodiodes, for example.

In these inventions noted above, one example of the image sensor is a slanted CCD type solid-state image sensor having a plurality of the charge storage devices extending in line form in an oblique direction, the photoelectric conversion devices being arranged horizontally and vertically parallel by the charge storage devices extending in line form in the oblique direction. If the charge storage devices in line form extended vertically, the photoelectric conversion devices would be arranged in an oblique direction. In this slanted CCD type solid-state image sensor, the photoelectric conversion devices are not arranged in such a way, but are in a rectangular arrangement.

In one example of these inventions noted above, the photoelectric conversion devices are photodiodes, the charge storage devices are CCD cells, the coupling device is a switching gate, and a write gate is disposed at a side of each photodiode for writing signal charges read from the photodiode in an adjoining one of the CCD cells, the switching gate being disposed as connected to the CCD cells on the side of one photodiode to be coupled, and disposed as connected to the write gate on the side of the other photodiode to be coupled. With this switching gate, the CCD cells are coupled together between one photodiode and the other photodiode to be coupled.

In the invention having such switching gate, preferably, the measurement is carried out by switching, based on potentials applied to the write gate, between (a') a state in which the switching gate couples together the CCD cells corresponding to the respective photodiodes, between the photodiode engaged in the measurement and the photodiode not engaged in the measurement, and the measurement is carried out while storing and memorizing the signal charges of the photodiode engaged in the measurement in both the CCD cells, and (b') a state in which both the CCD cells are uncoupled, and the measurement is carried out while storing and memorizing the signal charges of the individual photodiodes in the CCD cells corresponding to each. With the measurement carried out by switching, based on the potentials applied to the write gate, as noted above, the image sensor and image pickup apparatus can be realized as having high versatility, taking into account the usual photographic method according to the state (b').

### [EFFECTS OF THE INVENTION]

With the image sensor and the image pickup apparatus using the same, according to this invention, a coupling device is provided for coupling a plurality of charge storage devices together between a plurality of different photoelectric conversion devices. Between a photoelectric conversion device engaged in measurement by the photoelectric conversion and a photoelectric conversion device not engaged in the above measurement, the coupling device couples together the charge storage devices corresponding to the respective photoelectric conversion devices. The signal charges of the photoelectric conversion device engaged in the measurement are stored and memorized in the charge storage devices corresponding to the photoelectric conversion device, and the charge storage devices corresponding to the photoelectric conversion device not engaged in the measurement. Thus, the image sensor and the image pickup apparatus using the same can be realized as having high versatility even for different photographic methods.

### [BRIEF DESCRIPTION OF THE DRAWINGS]

[Fig. 1]
   (a) Block diagram showing an outline of an image pickup apparatus using a CCD type solid-state image sensor (CCD) according to an embodiment, and (b) View showing potential situations of potential of a write gate applied from a power source in the image pickup apparatus, and situations of charge storage units corresponding thereto.
[Fig. 2]
   Block diagram showing the construction of a CCD according to the embodiment.
[Fig. 3]
   Explanatory view showing a storage condition when the photodiodes are separated.
[Fig. 4]
   Explanatory view showing a storage condition when storage/vertical transfer CCD cells are coupled between a photodiode engaged in measurement and a photodiode not engaged in the measurement.
[Fig. 5]
   Explanatory view showing a storage condition when storage/vertical transfer CCD cells are coupled between photodiodes according to a modification.
[Fig. 6]
   (a), (b) Block diagrams showing a construction of a CCD according to a further modification.
[Fig. 7]
   Block diagram showing a construction of a conventional CCD.

### [Description of References]

- 1: CCD type solid-state image sensor (CCD)
- 9a: power source
- 9b: timing generator
- 11: photodiodes
- 12: storage CCDs
- 13: vertical transfer CCD cells
- 16: switching gates

### [BEST MODE FOR CARRYING OUT THE INVENTION]

In an image sensor and an image pickup apparatus using the same, when photodiodes are used as photoelectric conversion devices, and CCD cells are used as charge storage devices, switching gates are provided as coupling devices for coupling a plurality of charge storage devices together between a plurality of different photoelectric conversion devices. A write gate is disposed at a side of each photodiode for writing signal charges read from the photodiode in an adjoining CCD cell. Each switching gate noted above is connected to the CCD cells on the side of one photodiode to be coupled, and connected to the above write gate of the other adjoining photodiode to be coupled. With this arrangement, the CCD cells are coupled together between one photodiode and the other photodiode to be coupled. Signal charges of a photodiode engaged in measurement are stored and memorized in the CCD cells corresponding to the photodiode, and in the CCD cells corresponding to a photodiode not engaged in the measurement. Thus, the object of enhancing versatility even for different photographic methods has been fulfilled.

### [EMBODIMENT]

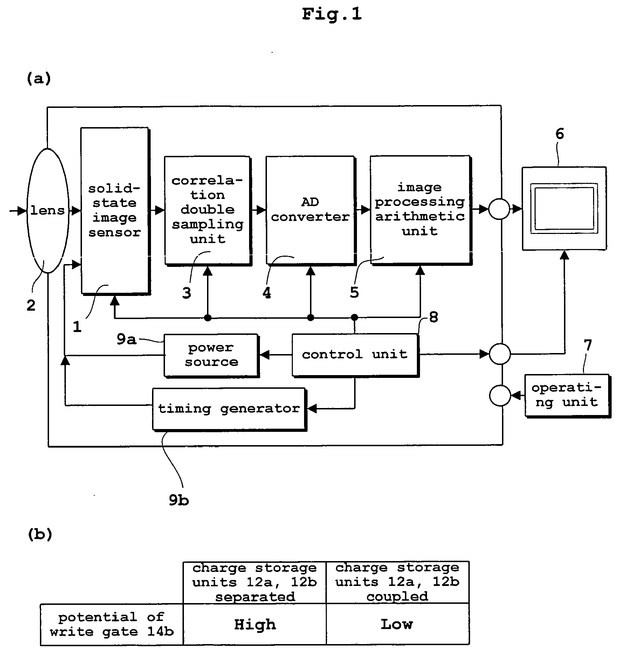

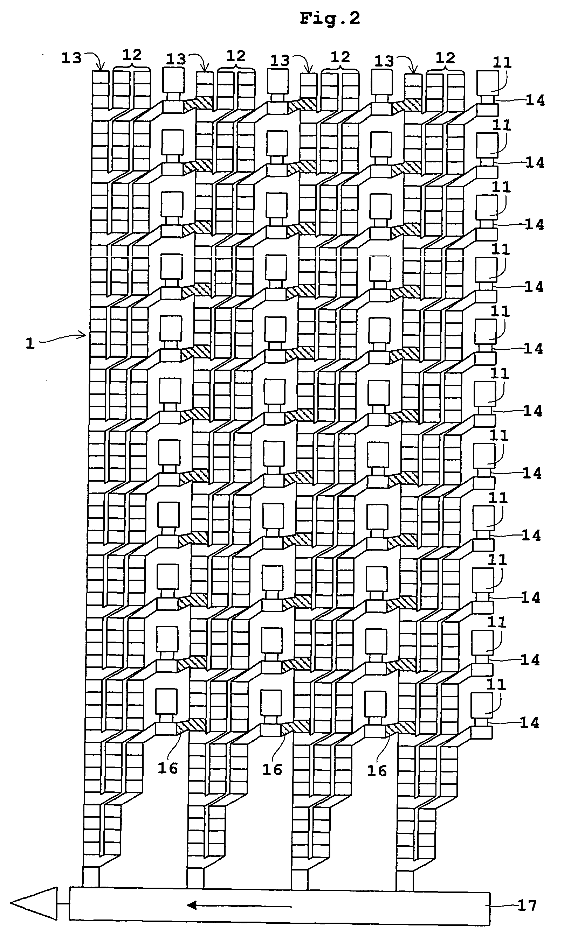

An embodiment of this invention will be described hereinafter with reference to the drawings. Fig. 1 (a) is a block diagram showing an outline of an image pickup apparatus using a CCD type solid-state image sensor (CCD) according to the embodiment. Fig. 1 (b) is a view showing potential situations of potential of a write gate applied from a power source in the image pickup apparatus, and situations of charge storage units corresponding thereto. Fig. 2 is a block diagram showing the construction of the CCD.

The image pickup apparatus according to the embodiment is constructed to acquire optical images of an object, convert the acquired optical images into signal charges and into electric signals, thereby picking up images of the object. Specifically, as shown in Fig. 1 (a), the image pickup apparatus includes a solid-state image sensor (CCD) 1, and includes a lens 2, a correlation double sampling unit 3, an AD converter 4, an image processing arithmetic unit 5, a monitor 6, an operating unit 7 and a control unit 8. Further, the image pickup apparatus includes a power source 9a and a timing generator 9b. The solid-state image sensor (CCD) 1 corresponds to the image sensor in this invention.

The lens 2 takes in optical images of the object. The correlation double sampling unit 3 amplifies signal charges from the CCD 1 to low noise, and converts them into electric signals for output. The AD converter 4 converts the electric signals into digital signals. The image processing arithmetic unit 5 performs various types of arithmetic processing to create two-dimensional images of the object based on the electric signals digitized by AD converter 4. The monitor 6 outputs the two-dimensional images on a screen. The operating unit 7 performs various operations required for execution of imaging. The control unit 8 carries out an overall control of the entire apparatus according to controls such as photographing conditions set by the operating unit 7.

The power source 9a applies voltage to transfer electrodes for transferring the signal charges in the CCD 1. The timing generator 9b generates timing of voltage application, timing of imaging, clocks and so on. In this embodiment, the timing generator 9b controls to establish synchronism with separation and coupling of the charge storage units described hereinafter, as shown in Fig. 1 (b). The power source 9a applies voltage to the write gates described hereinafter, based on the timing generator 9b, as shown in Fig. 1 (b). The power source 9a and timing generator 9b correspond to the charge transfer control device in this invention. A specific description of Fig. 1 (b) by the power source unit 9a and timing generator 9b will be made hereinafter with reference to Figs. 3 and 4.

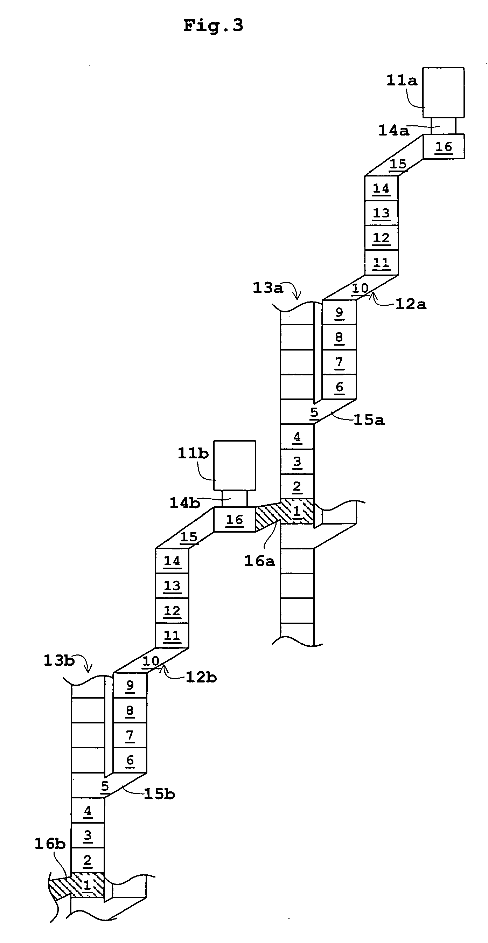

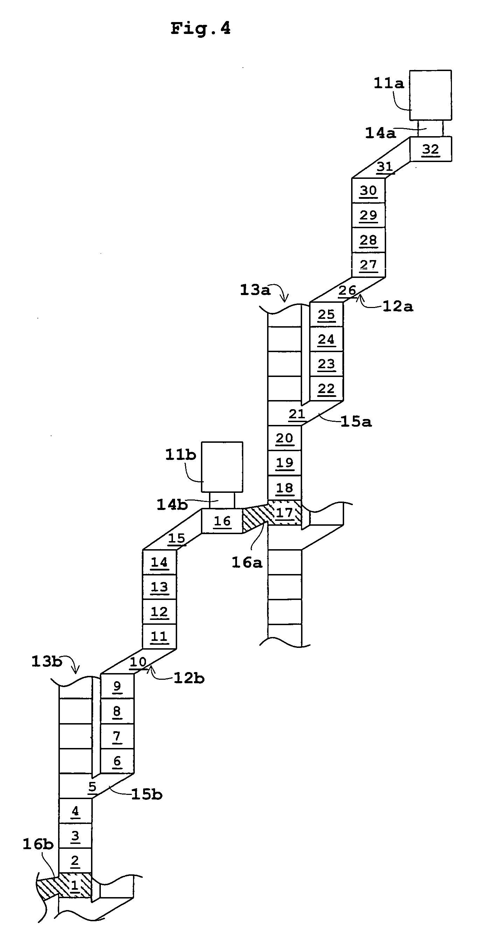

Next, a specific construction of CCD 1 will be described with reference to Fig. 2, while comparing it with Fig. 7 which is a block diagram showing the construction of a conventional CCD. A more particular construction will be described with reference to Figs. 3 and 4. Fig. 3 is an explanatory view showing a storage condition when the photodiodes are separated. Fig. 4 is an explanatory view showing a storage condition when storage/vertical transfer CCD cells are coupled between a photodiode engaged in measurement and a photodiode not engaged in the measurement.

As shown in Fig. 2, the CCD 1 includes photodiodes 11 for converting incident light (optical images of an object) into electric charges to generate signal charges corresponding to the intensity of the light, a plurality of storage CCD cells 12 for storing and memorizing the signal charges generated from the photodiodes 11, and vertical transfer CCD cells 13 for transferring the signal charges in these storage CCD cells 12 in a vertical direction shown in Fig. 2. The photodiodes 11 correspond to the photoelectric conversion devices in this invention. The storage CCD cells 12 and vertical transfer CCD cells 13 correspond to the charge storage devices in this invention.

Each photodiode 11 has a write gate 14 disposed at a side thereof. Each write gate 14 writes signal charges read from this photodiode 11 in a storage CCD cell 12 adjacent thereto.

The storage CCD cells 12 are connected to form lines, respectively, and a plurality of lines of storage CCD cells 12 are arranged. As shown in Figs. 3 and 4, the storage CCD cells 12 in line form are connected at downstream sides to confluence gates 15. These confluence gates 15 are connected to the vertical transfer CCD cells 13. The signal charges generated from the photodiodes 11 are stored in the respective storage CCD cells 12 while transferring them successively to the adjoining storage CCD cells 12. And the confluence gates 15 join the signal charges successively transferred from the storage CCD cells 12 to the vertical transfer CCD cells 13.

The photodiodes 11 are arranged two-dimensionally. Since the photodiodes 11 are arranged horizontally and vertically parallel, the storage CCD cells 12 in line form extend in an oblique direction. The CCD 1 according to this embodiment is what is called a "slanted CCD type solid-state image sensor".

In this embodiment, the difference from the conventional CCD (see Fig. 7) lies in the provision of switching gates 16 as shown in Figs. 3 and 4. In Figs. 2 - 4, to distinguish the difference from the prior art easily, the portions of switching gates 16 are shown in hatches of left slashes. The switching gates 16 are connected to the vertical transfer CCD cells 13, and also connected to the write gates 14 of adjoining photodiodes 11.

In Figs. 3 and 4, the photodiode 11 located in an upper right position of the drawings is called photodiode 11a, and the photodiode 11 in a lower left position of the drawings photodiode 11b. The storage CCD cells 12, vertical transfer CCD cells 13, write gate 14, confluence gate 15 and switching gate 16 corresponding to the photodiode 11a are called storage CCD cells 12a, vertical transfer CCD cells 13a, write gate 14a, confluence gate 15a and switching gate 16a, respectively. The storage CCD cells 12, vertical transfer CCD cells 13, write gate 14, confluence gate 15 and switching gate 16 corresponding to the photodiode 11b are called storage CCD cells 12b, vertical transfer CCD cells 13b, write gate 14b, confluence gate 15b and switching gate 16b, respectively.

With the above switching gate 16a, the storage/vertical transfer CCD cells 12a, 12b, 13a and 13b are coupled together between the photodiode 11a and the photodiode 11b located in the lower left position of the drawings as seen from the photodiode 11a. Regarding the other photodiodes 11 also, the storage/vertical transfer CCD cells 12 and 13 are coupled together between the photodiode 11 and the photodiode 11 located in the lower left position of the drawings as seen from the photodiode 11. The switching gates 16 correspond to the coupling devices in this invention.

When the photodiodes 11a and 11b are separated by separating the storage CCD cells 12a and 12b, as shown in Fig. 1 (b), the power source 9a (see Fig. 1 (a)) raises the potential of write gate 14b (indicated "High" in Fig. 1 (b)), to read the signal charges from the photodiode 11b to the storage CCD cells 12b corresponding thereto, and store and memorize them in the storage CCD cells 12b. At this time, the signal charges from the photodiode 11a are stored and memorized only in the storage CCD cells 12a corresponding thereto, and the signal charges are not written in the storage CCD cells 12b corresponding to the photodiode 11b. A storage condition at this time of separation is as shown in Fig. 3. This situation corresponds to the state (b) in this invention. This situation corresponds also to the state (b') in this invention.

Conversely, when the storage CCD cells 12a and 12b are coupled between the photodiode 11a and 11b, as shown in Fig. 1 (b), the power source 9a (see Fig. 1 (a)) lowers the potential of write gate 14b (indicated "Low" in Fig. 1 (b)) to function as a barrier gate. As a result, the signal charges from the photodiode 11b are not read to the storage CCD cells 12b. The signal charges from the photodiode 11a are stored and memorized in, while being transferred successively to, the storage CCD cells 12a corresponding thereto, and the storage CCD cells 12b corresponding to the photodiode 11b. The storage condition at this time of coupling is as shown in Fig. 4. This situation corresponds to the state (a) in this invention. This situation corresponds also to the state (a') in this invention.

When the photodiodes 11a and 11b are separated as shown in Fig. 3, and the signal charges from the respective photodiodes 11a and 11b are stored in the storage CCD cells 12a and 12b, the following takes place. First, the write gate 14a writes signal charge "1" read from the photodiode 11a in the storage CCD cell 12a adjacent thereto. Next, the write gate 14a writes signal charge "2" read from the photodiode 11a in the adjoining storage CCD cell 12a, and at the same time transfers and stores signal charge "1" to/in the adjoining storage CCD cell 12a.

The same procedure is repeated thereafter, and when the write gate 16a has written a 16th signal charge "16" in the storage CCD cell 12a adjacent thereto, as shown in Fig. 3, signal charges "1" to "16" are stored in order in the storage CCD cells 12a also including the vertical transfer CCD cells 13a. The numerals in the storage CCD cells 12a and vertical transfer CCD cells 13a in Fig. 3 indicate the signal charges "1" to "16". The photodiode 11b likewise stores signal charges "1" to "16" in order in the storage CCD cells 12b including the vertical transfer CCD cells 13b.

These signal charges "1" to "16" are successively transferred through the vertical transfer CCD cells 13a. The signal charges "1" to "16" transferred from the vertical transfer CCD cells 13a are transferred to horizontal transfer CCD cells 17 shown in Fig. 2.

When the storage CCD cells 12a and 12b are coupled between the photodiodes 11a and 11b as shown in Fig. 4, and the signal charges from the photodiode 11a are stored in the respective storage CCD cells 12a and 12b, the following takes place. It is the same as in Fig. 3 until signal charges "1" to "16" successively read from the photodiode 11a are stored in order in the storage CCD cells 12a also including the vertical transfer CCD cells 13a. When the write gate 16a writes a 17th signal charge "17" in the storage CCD cell 12a adjacent thereto, the switching gate 16a writes the first signal charge "1" in the storage CCD cell 12b corresponding to the photodiode 11b and located adjacent the write gate 16b. At this time, the power source 9a (see Fig. 1 (a)) lowers the potential of write gate 14b, causing it to function as a barrier gate, whereby the signal charges are not read from the photodiode 11b to the storage CCD cells 12b. Next, the write gate 14a writes signal charge "18" read from the photodiode 11a in the storage CCD cell 12a adjacent thereto. At the same time, signal charges "17" to "3" are stored in order in the storage CCD cells 12a also including the vertical transfer CCD cells 13a. The switching gate 16a writes the second signal charge "2" in the storage CCD cell 12b corresponding to the photodiode 11b and located adjacent the write gate 16b. At this time, the first signal charge "1" is transferred to and stored in the next adjoining storage CCD cell 12b.

The same procedure is repeated thereafter, and when the write gate 16a has written a 32nd signal charge "32" in the storage CCD cell 12a adjacent thereto, as shown in Fig. 4, signal charges "17" to "32" are stored in order in the storage CCD cells 12a also including the vertical transfer CCD cells 13a, and signal charges "7" to "16" are stored in order in the storage CCD cells 12b also including the vertical transfer CCD cells 13b. The numerals in the storage CCD cells 12a and 12b and vertical transfer CCD cells 13a and 13b in Fig. 4 indicate the signal charges "1" to "32".

These signal charges "1" to "16" are successively transferred through the vertical transfer CCD cells 13b. The signal charges "1" to "16" transferred from the vertical transfer CCD cells 13b are transferred to the horizontal transfer CCD cells 17 shown in Fig. 2. Each time signal charges "1" to "16" are successively transferred, signal charges "17" to "32" are stored in order in the storage CCD cells 12b also including the vertical transfer CCD cells 13b, and are successively transferred through the vertical transfer CCD cells 13b. The signal charges "17" to "32" transferred from the vertical transfer CCD cells 13b are also transferred to the horizontal transfer CCD cells 17 shown in Fig. 2.

From the photodiode 11b signal charges are not stored in the storage CCD cells 12b. That is, the photodiode 11a is a photodiode engaged in measurement by the photodiode 11a itself, while the photodiode 11b is a photodiode not engaged in the measurement.

According to the CCD 1 and the image pickup apparatus using the same as described above, the switching gates 16 are provided for coupling a plurality of storage/vertical transfer CCD cells 12 and 13 together between a plurality of different photodiodes 11. The switching gate 16a among the switching gates 16 couples together the storage/vertical transfer CCD cells 12a, 12b, 13a and 13b corresponding to the respective photodiodes 11a and 11b, between the photodiode 11a engaged in measurement by the photodiodes 11 and the photodiode 11b not engaged in the above measurement. Further, the signal charges of the photodiode 11a engaged in the measurement are stored and memorized in the storage CCD cells 12a (including the vertical transfer CCD cells 13a) corresponding to the photodiode 11a, and the storage CCD cells 12b (including the vertical transfer CCD cells 13b) corresponding to the photodiode 11b not engaged in the measurement. Therefore, when carrying out photography with importance attached to the number of storage CCD cells 12 including vertical transfer CCD cells 13, as shown in Fig. 4, the signal charges of the photodiode 11a engaged in the measurement are stored and memorized in the storage CCD cells 12a corresponding to the photodiode 11a, and the storage CCD cells 12b corresponding to the photodiode 11b not engaged in the measurement, thereby increasing the number of storage CCD cells 12 including vertical transfer CCD cells 13. Thus, the CCD 1 and image pickup apparatus can be realized as having high versatility even for different photographic methods.

When carrying out photography with importance attached to the number of storage CCD cells 12, the number of photographs and photographing time can be increased by increasing the number of storage CCD cells 12 including vertical transfer CCD cells 13. Since the photodiode 11b is not engaged in measurement, resolution falls correspondingly. Regarding the other photodiodes 11, the photodiode 11 in the right-hand side of the drawings of Figs. 2 - 4 serve as a photodiode 11 engaged in measurement, and the photodiode 11 in the left-hand side of the drawings serves as a photodiode 11 not engaged in the measurement. When the respective parts are coupled, resolution will fall by a degree corresponding to the photodiode 11 in the left-hand side. Thus, although resolution is unchanged in the vertical direction (lengthwise direction) in the drawings, resolution in the horizontal direction (transverse direction) becomes one half.

When carrying out photography with importance attached to the number of photodiodes 11, like usual photography, as shown in Fig. 3, the respective photodiodes 11a and 11b are separated instead of being coupled, and the signal charges of the individual photodiodes 11a and 11b are stored and memorized in the storage CCD cells 12a and 12b corresponding to the respective photodiodes 11a and 11b, thereby increasing the number of photodiodes 11. Thus, by carrying out measurement by switching to the states of Figs. 3 and 4, the CCD 1 and image pickup apparatus can be realized as having high versatility, taking into account the usual photographic method according to the state of Fig. 3.

When carrying out photography with importance attached to the number of photodiodes 11, like usual photography, the respective photodiodes 11a and 11b are separated instead of being coupled, to increase the number of photodiodes 11, which results in importance being attached to resolution.

In the image pickup apparatus according to this embodiment, the power source 9a and timing generator 9b (charge transfer control device) for controlling charge transfer are provided so that signal charges of the photodiode 11a engaged in measurement are stored and memorized in the storage CCD cells 12a corresponding to the photodiode 11a and the storage CCD cells 12b corresponding to the photodiode 11b not engaged in the measurement. Therefore, although the power source 9a and timing generator 9b are arranged outside the CCD 1, the functions corresponding to the power source 9a and timing generator 9b (charge transfer control device) may be provided in the CCD 1.

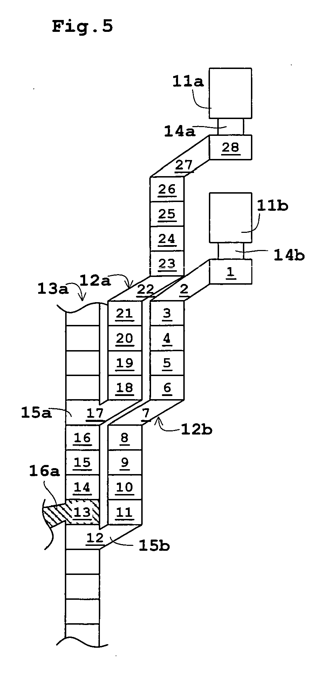

This invention is not limited to the foregoing embodiment, but may be modified as follows:
(1) The foregoing embodiment has been described, taking photodiodes as an example of photoelectric conversion devices, but this is not limitative. For example, photogates may be used as the photoelectric conversion devices.
(2) In the foregoing embodiment, the storage CCD cells are coupled together between two photodiodes. The storage CCD cells may be coupled between three or more photodiodes, and one may be used as a photodiode engaged in measurement, and the rest as photodiodes not engaged in the measurement. The same may be said of photoelectric conversion devices other than photodiodes.
(3) The foregoing embodiment has been described taking the "slanted CCD type solid-state image sensor" for example. This invention is applicable also to an image sensor having storage CCD cells in line form extending vertically.
(4) In the foregoing embodiment, between the photodiode 11a in the upper right position of the drawings of Figs. 3 and 4 and the photodiode 11b in the lower left position of the drawings, the storage/vertical transfer CCD cells 12a, 12b, 13a and 13b corresponding to the respective photodiodes 11a and 11b are coupled together. The photodiode 11a acts as a photodiode engaged in measurement, the other photodiode 11b as a photodiode not engaged in the measurement. The positional relationship between the photodiodes 11a and 11b is not limited to the relationship shown in Figs. 3 and 4.
   As shown in Fig. 5, for example, the photodiode 11 directly under the photodiode 11a may serve as a photodiode 11b not engaged in measurement. At this time, the storage CCD cells 12b, vertical transfer CCD cells 13b, write gate 14b and confluence gate 15b corresponding to the photodiode 11b are located in the positions shown in Fig. 5. In this case, the power source 9a (see Fig. 1 (a)) controls the potentials of the confluence gate 15b and the storage CCD cells 12a and 12b adjacent thereto, to store signal charges "13" to "28" in order in the storage CCD cells 12a also including the vertical transfer CCD cells 13a, write signal charge "12" in the confluence gate 15b, and store signal charges "1" to "11" in order in the storage CCD cells 12b also including vertical transfer CCD cells 13b. In this modification, the confluence gate 15b corresponds to the coupling device in this invention. The numerals in the storage CCD cells 12a and 12b and vertical transfer CCD cells 13a and 13b in Fig. 5 indicate signal charges "1" to "28".
   When transferring these signal charges "1" to "28" to the horizontal transfer CCD cells 17 shown in Fig. 2, the following procedure is carried out. First, signal charges "12" to "28" stored in order in the storage CCD cells 12a also including the vertical transfer CCD cells 13a are successively transferred through the vertical transfer CCD cells 13a. Signal charges "12" to "28" transferred from the vertical transfer CCD cells 13a are transferred to the horizontal transfer CCD cells 17 shown in Fig. 2. Each time signal charges "12" to "28" are successively transferred, signal charges "1" to "11" are stored in the order of "11" to "1" in the storage CCD cells 12a also including the vertical transfer CCD cells 13a, and are successively transferred through the vertical transfer CCD cells 13a. The signal charges "1" to "11" transferred from the vertical transfer CCD cells 13a are also transferred to the horizontal transfer CCD cells 17 shown in Fig. 2.
   The write gate 14b may be provided with a separate transfer path connected to the horizontal transfer CCD cells 17 shown in Fig. 2, so that signal charges "1" to "11" may be transferred to the horizontal transfer CCD cells 17 through the transfer path.
   As noted above, in the case of Fig. 5, regarding the other photodiodes 11, the upper photodiode 11 serves as a photodiode 11 engaged in measurement, and the photodiode 11 directly thereunder serves as a photodiode 11 not engaged in the measurement. When the respective parts are coupled, resolution will fall by a degree corresponding to the photodiode 11 directly under. Thus, although resolution is unchanged in the vertical direction (lengthwise direction) in the drawings, resolution in the horizontal direction (transverse direction) becomes one half.
(5) This invention is applicable also to any imaging mode. Imaging modes include mainly IL (Interline) mode, FT (Frame Transfer) mode, FFT (Full Frame Transfer) mode and FIT (Frame Interline Transfer) mode. The construction of the image sensor also is variable according to these modes.

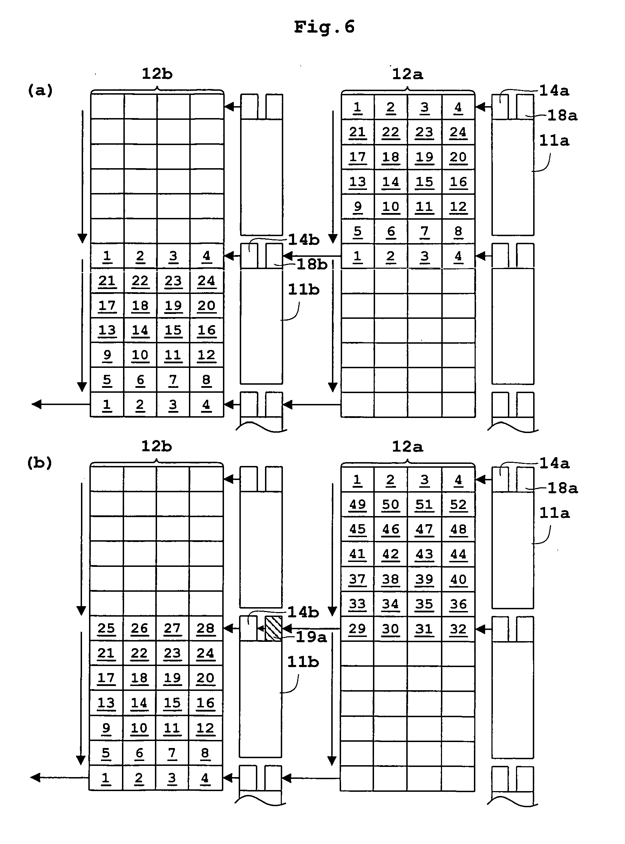

In the case of the construction shown in Fig. 6 (a), for example, each photodiode 11 has a two-dimensional arrangement of storage CCD cells 12, with a plurality of (four in Fig. 6 (a)) storage CCD cells 12 arranged horizontally, and a plurality of (six in Fig. 6 (a)) storage CCD cells 12 arranged vertically. In the case of usual photography, as shown in Fig. 6 (a), a write gate 14a writes signal charge "1" read from the photodiode 11a in the storage CCD cell 12a adjacent thereto. Until a fourth signal charge "4" is written in the storage CCD cell 12a adjacent the write gate 14a, signal charges "1" to "3" are horizontally and successively transferred to and stored in adjoining storage CCD cells 12a. Subsequently, the charges are successively transferred vertically and stored. That is, in the case of this embodiment, a total of 24 signal charges "1" to "24" are stored in the storage CCD cells 12 corresponding to one photodiode 11. When signal charges are newly written for signal charges in the storage CCD cells 12, the older signal charges are discharged to a drain 18 provided for the photodiode 11. In the case of Fig. 6 (a), the older signal charges "1" to "4" are discharged to a drain 18b provided for a photodiode 11b. The numerals in the storage CCD cells 12a in Fig. 6 (a) indicate signal charges "1" to "24."

As in the foregoing embodiment, when coupling together, as shown in Fig. 6 (b), the photodiode 11b is provided with a joint cell 19a in place of the drain 18b in Fig. 6 (a), for transfer to the write gate 14b. With this construction, the storage CCD cells 12a and 12b are coupled between the photodiodes 11a and 11b shown in Fig. 6 (b). In this modification, the joint cell 19a corresponds to the coupling device in this invention.

In the construction in Fig. 6 also, as in the above modification (4), the positional relationship between the photodiodes 11a and 11b is not limited to the relationship shown in Fig. 6. In the drawing of Fig. 6, the photodiode 11 directly under the photodiode 11a may serve as a photodiode 11b not engaged in measurement. Further, in the drawing of Fig. 6, the photodiode 11 to the right or left of the photodiode 11a may serve as a photodiode 11b not engaged in measurement.

### [INDUSTRIAL UTILITY]

As described above, this invention is suitable for an image sensor having photoelectric conversion devices, charge storage devices and so on arranged on the same chip.

## Claims

1. An image sensor for picking up images, **characterized by** comprising (1) a plurality of photoelectric conversion devices for converting incident light into electric charges to generate signal charges corresponding to intensity of the light; (2) a plurality of charge storage devices for storing and memorizing the signal charges generated from the photoelectric conversion devices; and (3) a coupling device for coupling a plurality of charge storage devices together between a plurality of different photoelectric conversion devices, wherein, through the coupling, the charge storage devices corresponding to the respective photoelectric conversion devices are coupled together between a photoelectric conversion device engaged in measurement by said photoelectric conversion, and a photoelectric conversion device not engaged in said measurement, and signal charges of the photoelectric conversion device engaged in said measurement are stored and memorized in the charge storage devices corresponding to the photoelectric conversion device, and the charge storage devices corresponding to the photoelectric conversion device not engaged in said measurement.

2. An image sensor as defined in claim 1, **characterized in that** the measurement is carried out by switching between (a) a state in which said coupling device couples together the charge storage devices corresponding to the respective photoelectric conversion devices, between the photoelectric conversion device engaged in said measurement and the photoelectric conversion device not engaged in said measurement, and the measurement is carried out while storing and memorizing the signal charges of the photoelectric conversion device engaged in the measurement in both the charge storage devices, and (b) a state in which both the charge storage devices are uncoupled, and the measurement is carried out while storing and memorizing the signal charges of the individual photoelectric conversion devices in the charge storage devices corresponding to each.

3. An image sensor as defined in claim 1, **characterized by** comprising (4) a charge transfer control device for controlling charge transfer such that the signal charges of the photoelectric conversion device engaged in said measurement are stored and memorized in the charge storage devices corresponding to the photoelectric conversion device, and the charge storage devices corresponding to the photoelectric conversion device not engaged in said measurement, said coupling device being operable under the control.

4. An image sensor as defined in claim 1, **characterized in that** said photoelectric conversion devices are photodiodes.

5. An image sensor as defined in claim 1, **characterized in that** said image sensor is a slanted CCD type solid-state image sensor having a plurality of said charge storage devices extending in line form in an oblique direction, said photoelectric conversion devices being arranged horizontally and vertically parallel by the charge storage devices extending in line form in the oblique direction.

6. An image sensor as defined in claim 1, **characterized in that** said photoelectric conversion devices are photodiodes, said charge storage devices are CCD cells, said coupling device is a switching gate, and a write gate is disposed at a side of each photodiode for writing signal charges read from the photodiode in an adjoining one of the CCD cells, said switching gate being disposed as connected to the CCD cells on the side of one photodiode to be coupled, and disposed as connected to said write gate on the side of the other photodiode to be coupled.

7. An image sensor as defined in claim 6, **characterized in that** the measurement is carried out by switching, based on potentials applied to said write gate, between (a') a state in which said switching gate couples together the CCD cells corresponding to the respective photodiodes, between the photodiode engaged in said measurement and the photodiode not engaged in said measurement, and the measurement is carried out while storing and memorizing the signal charges of the photodiode engaged in the measurement in both the CCD cells, and (b') a state in which both the CCD cells are uncoupled, and the measurement is carried out while storing and memorizing the signal charges of the individual photodiodes in the CCD cells corresponding to each.

8. An image sensor as defined in claim 1, **characterized in that** said coupling device couples a plurality of said charge storage devices horizontally between said photoelectric conversion devices.

9. An image sensor as defined in claim 1, **characterized in that** said coupling device couples a plurality of said charge storage devices vertically between said photoelectric conversion devices.

10. An image pickup apparatus using an image sensor, **characterized in that** the image sensor comprises (1) a plurality of photoelectric conversion devices for converting incident light into electric charges to generate signal charges corresponding to intensity of the light; (2) a plurality of charge storage devices for storing and memorizing the signal charges generated from the photoelectric conversion devices; and (3) a coupling device for coupling a plurality of charge storage devices together between a plurality of different photoelectric conversion devices, wherein, through the coupling, the charge storage devices corresponding to the respective photoelectric conversion devices are coupled together between a photoelectric conversion device engaged in measurement by said photoelectric conversion, and a photoelectric conversion device not engaged in said measurement, and signal charges of the photoelectric conversion device engaged in said measurement are stored and memorized in the charge storage devices corresponding to the photoelectric conversion device, and the charge storage devices corresponding to the photoelectric conversion device not engaged in said measurement.

11. An image pickup apparatus as defined in claim 10, **characterized in that** the measurement is carried out by switching between (a) a state in which said coupling device couples together the charge storage devices corresponding to the respective photoelectric conversion devices, between the photoelectric conversion device engaged in said measurement and the photoelectric conversion device not engaged in said measurement, and the measurement is carried out while storing and memorizing the signal charges of the photoelectric conversion device engaged in the measurement in both the charge storage devices, and (b) a state in which both the charge storage devices are uncoupled, and the measurement is carried out while storing and memorizing the signal charges of the individual photoelectric conversion devices in the charge storage devices corresponding to each.

12. An image pickup apparatus as defined in claim 10, **characterized by** comprising a charge transfer control device for controlling charge transfer such that the signal charges of the photoelectric conversion device engaged in said measurement are stored and memorized in the charge storage devices corresponding to the photoelectric conversion device, and the charge storage devices corresponding to the photoelectric conversion device not engaged in said measurement, said coupling device being operable under the control.

13. An image pickup apparatus as defined in claim 10, **characterized in that** said photoelectric conversion devices are photodiodes.

14. An image pickup apparatus as defined in claim 10, **characterized in that** said image sensor is a slanted CCD type solid-state image sensor having a plurality of said charge storage devices extending in line form in an oblique direction, said photoelectric conversion devices being arranged horizontally and vertically parallel by the charge storage devices extending in line form in the oblique direction.

15. An image pickup apparatus as defined in claim 10, **characterized in that** said photoelectric conversion devices are photodiodes, said charge storage devices are CCD cells, said coupling device is a switching gate, and a write gate is disposed at a side of each photodiode for writing signal charges read from the photodiode in an adjoining one of the CCD cells, said switching gate being disposed as connected to the CCD cells on the side of one photodiode to be coupled, and disposed as connected to said write gate on the side of the other photodiode to be coupled.

16. An image pickup apparatus as defined in claim 15, **characterized in that** the measurement is carried out by switching, based on potentials applied to said write gate, between (a') a state in which said switching gate couples together the CCD cells corresponding to the respective photodiodes, between the photodiode engaged in said measurement and the photodiode not engaged in said measurement, and the measurement is carried out while storing and memorizing the signal charges of the photodiode engaged in the measurement in both the CCD cells, and (b') a state in which both the CCD cells are uncoupled, and the measurement is carried out while storing and memorizing the signal charges of the individual photodiodes in the CCD cells corresponding to each.

17. An image pickup apparatus as defined in claim 10, **characterized in that** said coupling device couples a plurality of said charge storage devices horizontally between said photoelectric conversion devices.

18. An image pickup apparatus as defined in claim 10, **characterized in that** said coupling device couples a plurality of said charge storage devices vertically between said photoelectric conversion devices.
